# EUROPÄISCHE PATENTSCHRIFT

(11) **EP 4 312 473 B1**
(45) Veröffentlichungstag und Bekanntmachung des Hinweises auf die Patenterteilung: **28.08.2024**
(21) Anmeldenummer: 22187562.8
(22) Anmeldetag: 28.07.2022
(51) Int. Cl.: H05K 7/14

(54) **MODULAR AUFGEBAUTES AUTOMATISIERUNGSSYSTEM**
MODULAR AUTOMATION SYSTEM
SYSTÈME MODULAIRE D'AUTOMATISATION

(43) Veröffentlichungstag der Anmeldung: 31.01.2024
(73) Patentinhaber: Siemens Aktiengesellschaft, 80333 München (DE)
(72) Erfinder: Auerswald, Christian, 09131 Chemnitz (DE); Braeuning, Lydia Rowena, 09247 Chemnitz (DE); Bräunlich, Michael, 09117 Chemnitz (DE); Holtz, Stefan, 04277 Leipzig (DE); Traub, Andreas, 92224 Amberg (DE); Zurek, Frantisek, 09126 Chemnitz (DE)
(74) Vertreter: Siemens Patent Attorneys

(56) Entgegenhaltungen:
- DE-A1- 102014 111 031
- DE-A1- 102018 129 835
- US-A1- 2004 201 972

## Beschreibung

Die Erfindung betrifft ein modular aufgebautes Automatisierungssystem umfassend eine Haupteinheit mit einem Busanschluss-Steckverbinder, eine Mehrzahl an Modulen mit jeweils einem Bussteckverbinder und einen Signalsteckverbinder, und eine Hauptplatine auf der die Haupteinheit und die Module mit einer Mehrzahl an Anschlussmitteln angeordnet sind.

In der Automatisierungstechnik werden bei Steuerungssystemen und dezentralen Peripherielösungen über Ein-/Ausgabemodule benötigte Aktoren/Sensoren an die Ein- bzw. Ausgänge über Klemmen verbunden. Bei Serienmaschinen oder größeren Stückzahlen von gleichen Aufbauten oder Aufbauvarianten entsteht dabei ein hoher Arbeits- und Prüfaufwand. In solchen Fällen ist es vorteilhafter, die Signale nicht an den Klemmen des Steuerungsgerätes abzugreifen, sondern über Steckverbinder und beispielsweise vorkonfektionierte Kabel anzuschließen. Dazu muss allerdings das Steuerungssystem die Signale direkt auf eine kundenspezifische oder applikationsspezifische Leiterplatte ausgeben bzw. entgegennehmen. Die Leiterplatte weist wiederum Schnittstellen bzw. Steckverbinder für den anwendungsspezifischen Automatisierungsfall auf.

In der Veröffentlichung "Design-Guide zu EJ-Backplane für Twinsafe-Module" vom 29.01.2018 in der Version 1.5.1, wird bereits eine Lösung für anwendungsspezifische Aufbauten von Modulen und Steckverbindern auf einer Leiterplatte vorgeschlagen.

Das Dokument US 2004/201972 offenbart einen modular aufgebautes Automatisierungssystem umfassend eine Haupteinheit mit einem Busanschluss-Steckverbinder, eine Mehrzahl an Modulen mit jeweils einem Bussteckverbinder, eine Rückwandbusplatine in einem Lagenaufbau mit Busleiterbahnen die an eine Mehrzahl an Modulsteckverbindern angeschlossen ist, in denen die Bussteckverbinder der Module angeordnet sind, wobei eine Hauptplatine auf der eine Mehrzahl an Modulsteckverbindern angeordnet ist und wobei die Rückwandbusplatine in der Hauptplatine angeordnet ist, die Module sind dabei dazu ausgestaltet über die Bussteckverbinder mittels der Rückwandbusplatine mit der Haupteinheit zu kommunizieren, wobei die Busleiterbahnen und der Lagenaufbau der Rückwandbusplatine derart ausgestaltet sind, dass ein Schichtstapel die Busleiterbahnen und Kernmaterial umfasst.

Bei den bekannten modular aufgebauten Automatisierungssystem ist es von Nachteil, dass das Layout bzw. das Routing von einem Rückwandbus der aufgebrachten Module immer wieder neu erstellt werden muss und vom Hersteller der Module auf Fehlersicherheit überprüft werden muss. Ein weiterer Nachteil ist das für das bekannte modular aufgebaute Automatisierungssystem veränderte Module bereitgestellt werden müssen, welche das vorhandene Modulspektrum eines Herstellers noch einmal um ein weiteres Modul erweitern. Das spezielle Routen für den Rückwandbus, nämlich den Logikbus auf der Backplane für die Module hat zur Folge, dass die Kosten für die Backplane steigen. Da für den Logikbus Vorgaben hinsichtlich Impedanz und Hochfrequenzverhalten des Herstellers gelten.

Erfindungsgemäß werden die aufgezeigten Nachteile durch die folgende Merkmalskombination für ein modular aufgebautes Automatisierungssystem gelöst. Dabei umfasst das modular aufgebaute Automatisierungssystem eine Haupteinheit mit einen Busanschlusssteckverbinder, eine Mehrzahl an Modulen mit jeweils einem Bussteckverbinder und einem Signalsteckverbinder, eine Rückwandbusplatine in einem Lagenaufbau mit Busleiterbahnen, an welche eine an Mehrzahl an Modulsteckverbinder angeschlossen sind in denen wiederum die Bussteckverbinder der Module angeordnet sind, eine Hauptplatine auf der eine Anzahl an Verbinder-Elementen angeordnet sind, wobei die Signalsteckverbinder der Module in den Verbinder-Elementen angeordnet sind und die Verbinder-Elemente mit Leiterbahnen der Hauptplatine elektrisch in Kontakt stehen, weiterhin umfassend eine Mehrzahl an Anschlussmitteln, welche auf der Hauptplatine angeordnet sind und mit den Leiterbahnen der Hauptplatine derart elektrisch in Kontakt stehen, dass elektrische Verbindungswege zwischen den Verbinder-Elementen und damit zu den Modulsteckverbindern der Module und den Anschlussmitteln vorhanden sind, wobei die Anschlussmittel ausgestaltet sind, für den Anschluss an Prozesssignalkabel, die Module sind dabei ausgestaltet über die Bussteckverbinder mittels der Rückwandbusplatine mit der Haupteinheit zu kommunizieren und Logik-Ausgaben der Haupteinheit als Signale an die Signalsteckverbinder weiterzugeben, auch sind die Module dazu ausgestaltet Signale an den Signalsteckverbindern, welche von den Anschlussmitteln kommen als Logik-Eingaben über die Bussteckverbinder und die Rückwandbusplatine an die Haupteinheit weiterzugeben, wobei die Busleiterbahnen und der Lagenaufbau der Rückwandbusplatine derart ausgestaltet sind, dass ein Schichtstapel umfassend die Busleiterbahnen und Kernmaterial Merkmale enthält, die zur Aufrechterhaltung der Signalintegrität der Signale auf der Rückwandbusplatine erforderlich sind, und somit im Hinblick auf die Signalintegrität der Signale auf der Rückwandbusplatine, diese separat auf der Hauptplatine angeordnet ist.

Die Erfinder haben erkannt, dass es bei einen modular aufgebauten Automatisierungssystem auf einer Hauptplatine von Nachteil ist, dass ein Kunde, welcher sich ein derart modulares Automatisierungssystem auf einer Hauptplatine aufbauen muss, immer berücksichtigen muss, wie er das Routing bzw. die Entflechtung und die Gestaltung der Leiterbahn für den Rückwandbus der Module macht ohne gegen eine zertifizierte Vorgabe für die Signalintegrität der Signale auf einem Rückwandbus zu achten. Das bedeutet, dass das Routen bzw. Entflechten eines Logikbusses auf der Hauptplatine zur Folge hat, dass für die Hauptplatine die Kosten steigen, da für den Logikbus Vorgaben hinsichtlich Impedanz und HF-Verhalten gelten.

Mit Vorteil wird nun eine Logikbusverdrahtung, nämlich die Verdrahtung der Busleiterbahnen auf der Rückwandbusplatine über eine von einen Steuerungshersteller entworfene und bereits getestete zertifizierte eigene Flachbaugruppe bereitgestellt, die nur auf die jeweilige Hauptplatine aufgelegt werden muss.

Im Sinne der Erfindung ist unter Signalintegrität die Qualität eines zu übertragenen digitalen Signales von beispielsweise einem Treiber (Sender) eines Modules zu der Haupteinheit und umgekehrt zu verstehen. Eine Signalintegrität kann auf einer Leiterbahn beispielsweise auf einem Multi-Layer durch die Effekte Cross-talk (Übersprechen) und Reflektionen (Impedanzverhalten) oder allgemein mit der Impedanz der Leiterbahn und dem Wellenwiderstand negativ beeinflusst werden. Bei Rückwandbusplatinen, auf welchen Hochgeschwindigkeitssignale übertragen werden, dürfen die parasitären Effekte einer Kupferleitung auf der Leiterplatte nicht mehr vernachlässigt werden. Eine Impedanz einer Leiterbahn ist u.a. von deren Geometrie abhängig und verändert sich beispielsweise bei Kurven, oder einem Lagenwechsel oder bei Durchkontaktierungen. Darüber hinaus müssen die Signalleitungen bzw. die Leiterbahnen bezüglich ihrer Impedanz an ihren Enden oder Empfängern richtig abgeschlossen sein. All diese Merkmale wie Impedanz, Lagenaufbau, Stärke des Kernmaterials, mögliche Abschlusswiderstände entsprechen den Merkmalen, die zur Aufrechterhaltung der Signalintegrität der Signale auf der Rückwandbusplatine erforderlich sind. Der Hersteller eines solchen Systems hat also einmal den Rückwandbus bezüglich der Signalintegrität getestet und freigegeben und gewährleistet somit eine sichere Datenübertragung.

Weiterhin ist es von Vorteil, wenn die Rückwandbusplatine zwischen der Hauptplatine und einem Modul-Sockel angeordnet ist, wobei der Modul-Sockel als Befestigungsbasis für die Module ausgestaltet ist und auf der Hauptplatine angeordnet ist und der Modulsockel eine erste Ausnehmung für einen der Modulsteckverbinder und eine zweite Ausnehmung für eines der Verbinderelemente aufweist.

Dies hat den besonderen Vorteil, dass ein bereits entwickeltes Modulspektrum für beispielsweise einen Hutschienenaufbau auch für eine Hauptplatinenlösung im modularen Aufbau weiterverwendet werden kann. Das reduziert einen Entwicklungs-, Betreuungs- und Fertigungsaufwand der verwendeten Module ganz erheblich. Weiterhin ist es von Vorteil, dass sich ein Entwicklungsaufwand einer Hauptplatinenlösung minimal gestaltet, da ein Kunde, welcher die anwenderspezifische Lösung realisieren will, außer einigen Aufbauregeln in der Hauptplatine nur seine gewünschten Funktionen realisieren muss und eine, bezüglich der Signalintegrität erforderlichen Entflechtung eines Rückwandbusses nicht beachten muss.

Mit einer derart realisierten Lösung durch die Rückwandbusplatine sind alle bereits existierenden Komponenten auch für einen Hauptplatinenaufbau sofort verfügbar.

Weiterhin ist es von Vorteil, wenn ein Kunde mit einer Hauptplatinen-Lösung auch weitere I/O-Module einsetzen will, muss er nicht verschiedene Modultypen als Ersatzteile bereithalten.

Weiterhin ist es vorteilhaft, wenn ausgehend von einer ersten Rückwandbusplatine, welche über einen ersten Modulsteckverbinder mit dem Busanschlusssteckverbinder der Haupteinheit verbunden ist, eine zweite Rückwandbusplatine an die erste Rückwandbusplatine über einen Platinenverbinder angeschlossen ist.

Eine Anzahl von benötigten Steckplätzen für die eingesetzten Module ist von der jeweiligen applikationsspezifischen Anwendung bzw. von einer Kundenanforderung abhängig. Ein Steuerungshersteller kann nun einzelne verschieden lange Rückwandbusplatinen entwickeln und durch diese Segmentierung einen Kunden einen Baukasten für eine jeweilige Aufgabe anbieten. So muss nicht für jede Anforderung eine eigene Rückwandbusplatine entwickelt und getestet werden.

Ein weiterer Vorteil ist es, wenn die Hauptplatine einen Schutzbaustein aufweist, welcher über einen Bausteinsockel in die Verbindungswege auf der Hauptplatine geschaltet ist, und ausgestaltet ist, ein Modul hinsichtlich einer Überspannung, einer Verpolung oder einer hochfrequenten Störung zu schützen. Bei den bereits im Modulspektrum befindlichen Modulen war oder ist es üblich, beispielsweise eine Einspeisung einer 24V-DC Lastversorgung für ein oder mehrere I/O-Module in einem Steuerungssystem verschiedene elektrische Schutzmaßnahmen einem separat zu steckenden Modul zu implementieren, um die entsprechenden Zulassungen der einzelnen Baugruppen und deren Funktion zu sichern. Dazu zählen ein Überspannungsschutz, ein Verpolschutz und ein Tiefpassfilter zum Dämpfen von hochfrequenten Störungen. Diese Schutzmaßnahmen waren in der Regel in einem separaten Einspeisemodul integriert oder in speziellen Base Units untergebracht. Dabei sind bei elektrischen Prüfungen/Zulassungen genau definierte Verhältnisse bezüglich der verwendeten Bauteile und des entsprechenden Leiterplattenlayouts erforderlich. Bevorzugt nun aber ein Anwender für seinen applikationsspezifischen Automatisierungsaufbau eine Hauptplatinenlösung, müssten diese Schutzfunktionen in die Hauptplatine integriert werden oder es ist wiederum die Verwendung eines speziellen Einspeisemoduls zwingend erforderlich. Dies würde jedoch den eigentlichen Aufbau entsprechend vergrößern. Aus diesem Grund wurde ein Schutzbaustein entworfen, der die elektrische Schutzfunktionen realisiert und anwenderseitig einfach auf die Hauptplatine aufgesteckt werden kann.

Ein weiterer Vorteil ist darin zu sehen, dass die Hauptplatine als eine anwendungsspezifische Leiterkarte mit einem Leiterbahnlayout für die Verteilwege für die Signale und die Spannungsversorgung auf einzelne anwendungsspezifische als Steckverbinder ausgestaltete Anschlussmittel ausgestaltet ist, um die Haupteinheit mit für die spezifische Anwendung zugehörigen Maschinenmodulen zu verbinden.

Zusammengefasst kann gesagt werden, dass man nun eine Lösung dafür gefunden hat, ein bereits existierendes Steuerungssystem mit zwei rückseitig angeordneten Steckverbindern für eine anwendungsspezifische Hauptplatinenlösung einzusetzen.

Das hier genannte Konzept mit der separat aufgebrachten Rückwandbusplatine dient der Gewährleistung der Signalintegrität für die Buskommunikation der Module zur Haupteinheit und zurück. Nun liegt eine Rückwandbusplatine vor, bei welcher die Merkmale zur Erfüllung der Signalintegrität berücksichtigt wurden. Dazu gehören eine genaue Impedanzkalkulation der Leiterbahnen zur Vermeidung von Signalreflektionen. Verluste und Streuung bei der Ausbreitung auf langen Verbindungen sind zu vermeiden. Ein Übersprechen aufgrund von schnell schaltenden digitalen Signalen auf eine Nachbarleiterbahn gilt es ebenfalls durch geometrische Berücksichtigung des Aufbaus zu vermeiden. Ein Über- und Unterschwingen von digitalen Signalen wird bei einem signalintegritätsverbindlichen Aufbau ebenfalls vermieden. Auch sollen zusätzliche Verluste aufgrund einer Kupferrauheit entlang einer Verbindung vermieden werden.

In anderen Worten besteht das Ziel dieser Signalintegrität-Praktiken mit einem geeigneten Rückwandplatinenlayout sicherzustellen, dass die Qualität eines Signals bei der Übertragung von einer Treiben-Komponente zu einer Empfänger-Komponente sich nicht verschlechtert.

Die Zeichnung zeigt ein Ausführungsbeispiel eines modular aufgebauten Automatisierungssystem mit seinen Komponenten. Es zeigt:
- FIG 1: das modular aufgebaute Automatisierungssystem 1 in einer perspektivischen Ansicht,
- FIG 2: ein Modul EA in einer perspektivischen Ansicht von vorne,
- FIG 3: das Modul EA in einer perspektivischen Ansicht von hinten,
- FIG 4: das Modul EA in einer weiteren perspektivischen Ansicht von hinten ohne einen angebrachten Modulsockel,
- FIG 5: eine Rückwandbusplatine,
- FIG 6: zwei zusammengesteckte Rückwandbusplatinen,
- FIG 7: eine schematische Darstellung des modularen Aufbaus mit gestecktem Schutzbaustein und
- FIG 8: einen Schichtstabel.

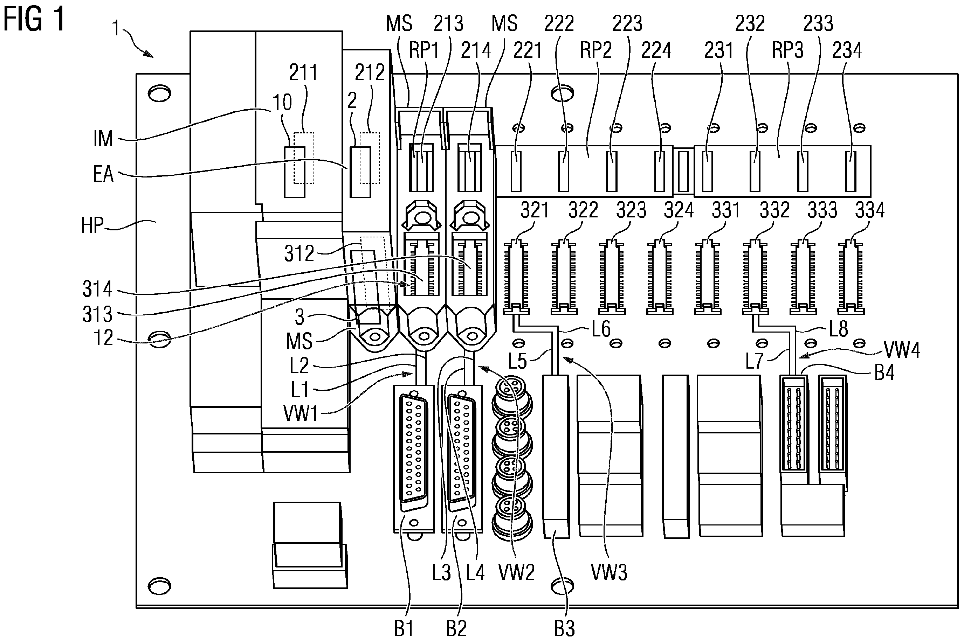

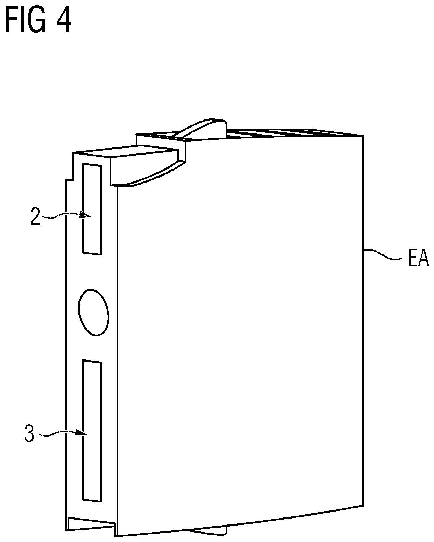

Gemäß FIG 1 ist ein modular aufgebautes Automatisierungssystem 1 mit einer Haupteinheit IM und einer Mehrzahl an Modulen EA dargestellt. Links neben der Haupteinheit IM ist weiterhin ein Mittel zur Spannungsversorgung angeordnet. Die Haupteinheit IM verfügt auch über Busschnittstellen, um zu übergeordneten Automatisierungssystemen zu kommunizieren. Das modulare Automatisierungssystem 1 lässt sich durch eine Aneinanderreihung einer Vielzahl von Modulen EA modular aufbauen. Direkt rechts neben der Haupteinheit IM wäre sodann ein erstes Module EA angeordnet. Neben diesen können weitere Module nach rechtsangefügt werden. Auf einer Hauptplatine HP sind die Haupteinheit IM und die Module über Modulsockel MS angebracht. Es können demnach eine Mehrzahl an Modulen EA mit jeweils einem Bussteckverbinder 2 und einem Signalsteckverbinder 3 (siehe auch FIG 4) auf der Hauptplatine HP angeordnet werden. Damit die Module EA mit der Haupteinheit IK kommunizieren können, ist eine Rückwandbusplatine RP1,RP2,RP3 in einem Lagenaufbau mit Busleiterbahnen BL1,...,BL4 an eine Mehrzahl an Modulsteckverbindern 211,...,234 angeschlossen. Die Bussteckverbinder 2 der Module EA stecken dementsprechend in den Modulsteckverbindern 211,...,234. Beispielhaft wird es an dem ersten Modul EA schematisch durch Linien und gestrichelte Linien der Bussteckverbinder 2 und des ersten Modulsteckverbinders 212 angedeutet. Ebenso steckt der Signalsteckverbinder 3 des ersten Moduls EA in einem ersten Verbinder-Element 312. Die Haupteinheit IM ist entsprechend über einen Busanschlusssteckverbinder 10 mit einem ersten Modulsteckverbinder 211 verbunden, dies stellt den Kontakt der Haupteinheit IM zur ersten Rückwandbusplatine RP1 her. Dementsprechend sind auf der Hauptplatine HP eine Mehrzahl an Verbinder-Elementen 312,...,334 angeordnet und die entsprechenden Signalsteckverbinder 3 der Module EA können in die Verbinder-Elemente 312,...,334 gesteckt werden. Die Verbinder-Elemente 312,...,334 stehen mit Leiterbahnen L1,...,L8 der Hauptplatine HP elektrisch in Kontakt. Weiterhin ist auf der Hauptplatine HP eine Mehrzahl an Anschlussmitteln B1,B2,B3,B4 vorhanden. Die Anschlussmittel B1,B2,B3,B4 stehen anwendungsspezifisch mit den Leiterbahnen L1,...,L8 der Hauptplatine HP derart elektrisch in Kontakt, das elektrische Verbindungswege VW1,...,VW4 zwischen den Verbinder-Elementen 312,...,334 entstehen. Dementsprechend gibt es elektrische Verbindungen zwischen den Signalsteckverbindern 3 der Module EA und den Anschlussmitteln B1,...,B4. Die Anschlussmittel B1,...,B4 sind ausgestaltet für den Anschluss an Prozess-Signalkabel. Demzufolge ist die Hauptplatine HP als eine anwendungsspezifische Leiterkarte mit einen Leiterbahnlayout für Verteilwege für die Signale und die Spannungsversorgung auf einzelne anwendungsspezifische als Steckverbinder ausgestaltete Anschlussmittel B1,...,B4 ausgestaltet um die Haupteinheit IM für die spezifische Anwendung mit zu der spezifischen Anwendung zugehörigen Maschinenmodulen zu verbinden.

Die Module EA sind dazu ausgestaltet, über die Bussteckverbinder 2 mittels der Rückwandbusplatine RP1,RP2,RP3 mit der Haupteinheit IM zu kommunizieren und Logik-Ausgaben der Haupteinheit IM als Signale an die Signalsteckverbinder 3 weiterzugeben. Auch sind die Module EA weiter dazu ausgestaltet, Signale an den Signalsteckverbindern 3, welche von den Anschlussmitteln B1,...,B4 kommen, als Logik-Eingaben über die Bussteckverbinder 2 und die Rückwandbusplatine RP1,RP2,RP3 an die Haupteinheit IM weiterzugeben.

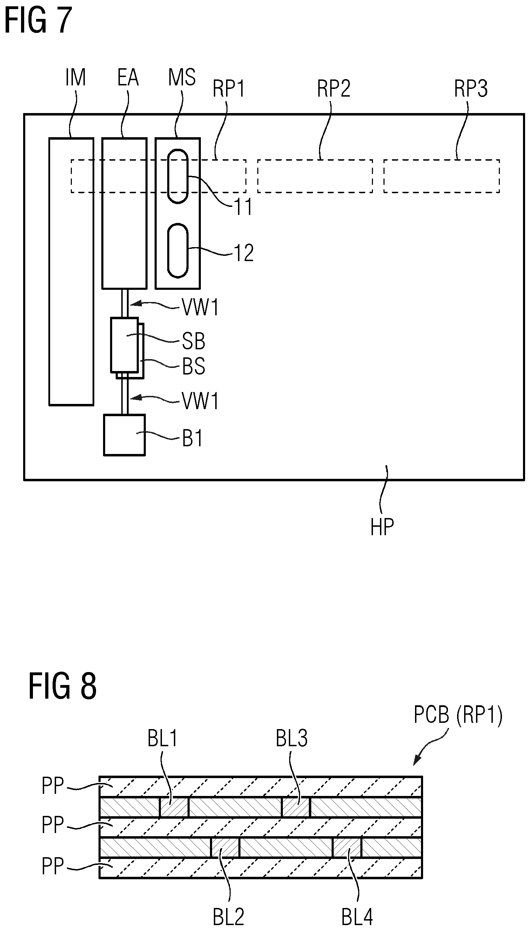

Die Rückwandbusplatinen RP1,RP2,RP3 sind bezüglich ihrer Busleiterbahnen BL1,...,BL4 und ihres Lagenaufbaus derart ausgestaltet, dass ein Schichtstabel PCB umfassend die Busleiterbahnen BL1,...,BL4 und Kernmaterial PP Merkmale enthält, die zur Aufrechterhaltung der Signalintegrität der Signale auf der Rückwandbusplatine RP1,RP2,RP3 erforderlich sind und somit im Hinblick auf die Signalintegrität der Signale auf der Rückwandbusplatine RP1,RP2,RP3, diese separat auf der Hauptplatine HP angeordnet ist (siehe FIG 8).

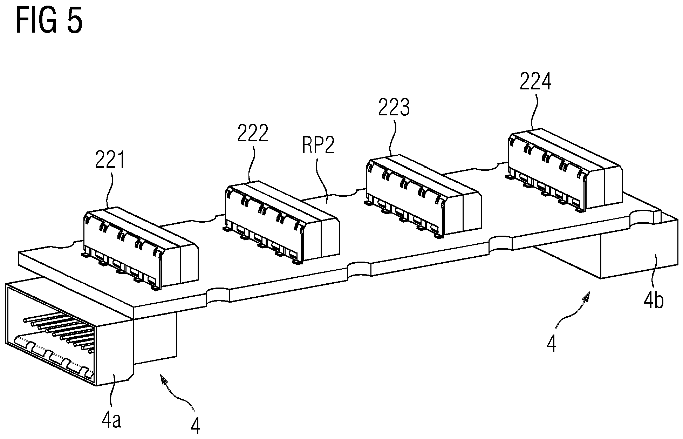

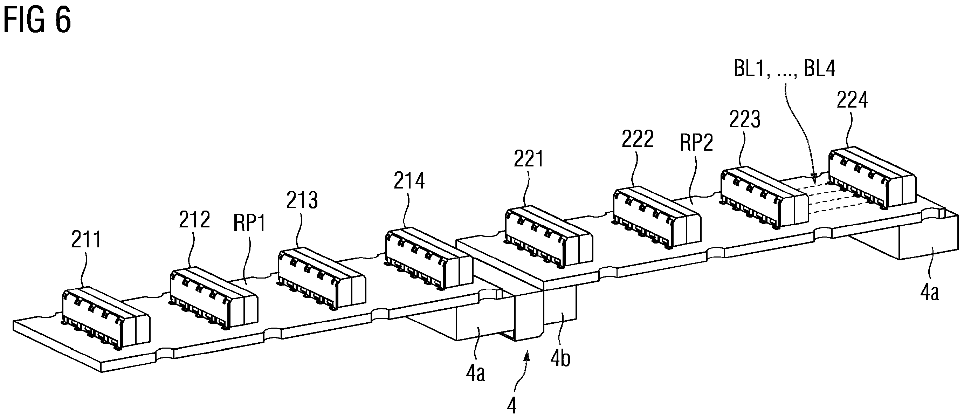

Möchte man mehrere Rückwandbusplatinen RP1,RP2,RP3 auf der Hauptplatine HP unterbringen, so verfügt die Hauptplatine HP über Ausnehmungen in denen Platinenverbinder 4 angeordnet werden können (sieh hierzu FIG 5 und insbesondere FIG 6). Ein Modulsockel MS wird mit Verschraubungsmitteln auf der Hauptplatine HP aufgeschraubt, dabei weist der Modulsockel MS eine erste Ausnehmung 11 für einen der Modulsteckverbinder 211,...,234 und eine zweite Ausnehmung 12 für eines der Verbinderelemente 312,...,334 auf. Die Rückwandbusplatine RP1,RP2,RP3 ist demnach zwischen der Hauptplatine HP und dem Modul-Sockel MS angeordnet. Der Modul-Sockel MS dient als Befestigungsbasis für die Module EA. Die Module EA können beispielsweise über Verrastnasen in die Modul-Sockel MS eingeschnappt werden und gehen dabei elektrische Verbindungen mit den entsprechenden Steckverbindern auf der Hauptplatine HP bzw. auf der Rückwandbusplatine RP1,RP2,RP3 ein.

Über die Platinensteckverbinder 4 kann eine erste Rückwandbusplatine RP1, welche über einen ersten Modulsteckverbinder 211 mit dem Busanschluss-Steckverbinder 10 der Haupteinheit verbunden ist, an eine zweite Rückwandbusplatine RP2 angeschlossen werden.

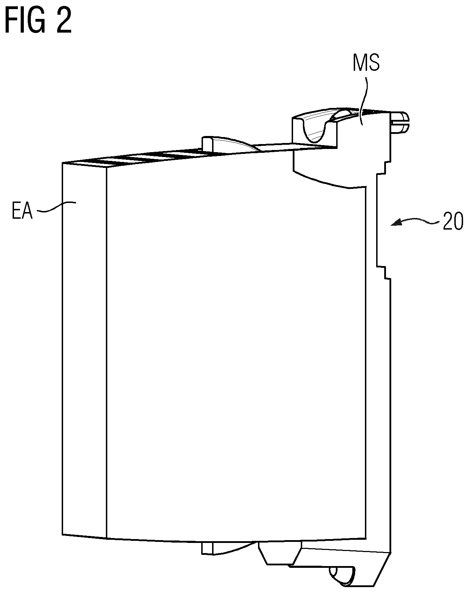

Die FIG 2 zeigt das Modul EA in einer perspektivischen Ansicht von vorne, dabei ist das Module EA in dem Modul-Sockel MS eingeschnappt. Die Rückseite des Modul-Sockels MS weist eine Aussparung 20 für die auf der Hauptplatine HP angebrachte Rückwandbusplatine RP1 auf.

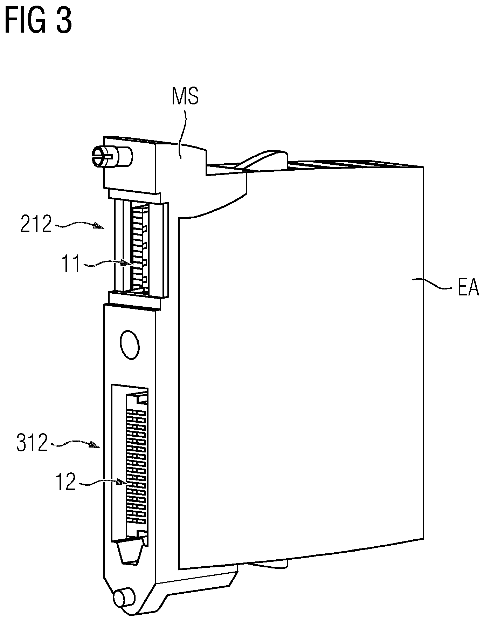

Mit der FIG 3 ist eine andere perspektivische Darstellung des Moduls EA aus FIG 2 gezeigt, nämlich eine perspektivische Ansicht auf die Rückseite des Moduls EA. In der ersten Ausnehmung 11 ist exemplarisch der zweite Modulsteckverbinder 212 dargestellt. In der zweiten Ausnehmung 12 ist exemplarisch das erste Verbinderelement 312 dargestellt.

Mit der FIG 4 wird das Modul EA aus FIG 3 mit losgelöstem Modulsockel MS gezeigt. Das Modul EA weist auf seiner Rückseite jeweils einen Bussteckverbinder 2 und einen Signalsteckverbinder 3 auf.

Die FIG 5 zeigt exemplarisch die zweite Rückwandbusplatine RP2 auf die ein der zweiten Rückwandbusplatine RP2 zugehöriger erster Modulsteckverbinder 221, ein zweiter Modulsteckverbinder 222, ein dritter Modulsteckverbinder 223 und ein vierter Modulsteckverbinder 224 angeordnet ist. Damit mehrere Rückwandbusplatinen RP1,RP2,RP3 hintereinander verschaltet werden können, weist die zweite Rückwandbusplatine RP2 einen Platinensteckverbinder 4 auf, welcher sich in einen Weibchen-Steckverbinder 4a und einen Männchen-Steckverbinder 4b aufteilt.

Die FIG 6 zeigt die erste Rückwandbusplatine RP1 und die zweite Rückwandbusplatine RP2, welche über den Platinensteckverbinder 4 mit einem Weibchen 4a und einem Männchen 4b verbunden sind. In der zweiten Rückwandbusplatine RP2 sind schematisch eine erste Busleiterbahn BL1, eine zweite Busleiterbahn BL2 eine dritte Busleiterbahn BL3 und eine vierte Busleiterbahn BL4 eingezeichnet.

FIG 7 zeigt eine schematische Anordnung eines Schutzbausteins SB auf der Hauptplatine HP. Die Schutzbausteine SB sind über einen Bausteinsockel BS in die Verbindungswege VW1,...,VW4 geschaltet. Die Schutzbausteine SB sind ausgestaltet, ein Module EA hinsichtlich einer Überspannung, einer Verpolung und/oder einer hochfrequenten Störung zu schützen.

## Patentansprüche

1. Modular aufgebautes Automatisierungssystem (1) umfassend
- eine Haupteinheit (IM) mit einem Busanschluss-Steckverbinder (10),
- eine Mehrzahl an Modulen (EA) mit jeweils einem Bussteckverbinder (2) und einem Signalsteckverbinder (3),
- eine Rückwandbusplatine (RP1,RP2,RP3) in einem Lagenaufbau mit Busleiterbahnen (BL1,...,BL4) ist an eine Mehrzahl an Modulsteckverbindern (211,...,234) angeschlossen, in denen die Bussteckverbinder (2) der Module (EA) angeordnet sind,
- eine Hauptplatine (HP) auf der eine Mehrzahl an Verbinder-Elementen (312,...,334) angeordnet ist, wobei die Signalsteckverbinder (3) der Module (EA) in den Verbinder-Elementen (312,...,334) angeordnet sind und die Verbinder-Elemente (312,...,334) mit Leiterbahnen (L1,..,L8) der Hauptplatine (HP) elektrisch in Kontakt stehen,
- eine Mehrzahl an Anschlussmitteln (B1,B2,B3,B4), welche auf der Hauptplatine (HP) angeordnet sind und mit den Leiterbahnen (L1,...,L8) der Hauptplatine (HP) derart elektrisch in Kontakt stehen, dass elektrische Verbindungswege (VW1,...,VW4) zwischen den Verbinder-Elementen (312,...,334) und damit zu den Signalsteckverbindern (3) der Module (EA) und den Anschlussmitteln (B1,B2,B3,B4), vorhanden sind, wobei die Anschlussmittel (B1,B2,B3,B4), ausgestaltet sind für den Anschluss an Prozess-Signalkabel,
- die Module (EA) sind dabei dazu ausgestaltet über die Bussteckverbinder (2) mittels der Rückwandbusplatine (RP1,RP2,RP3) mit der Haupteinheit (IM) zu kommunizieren und Logik-Ausgaben der Haupteinheit (IM) als Signale an die Signalsteckverbinder (3) weiterzugeben,
- auch sind die Module (EA) dazu ausgestaltet Signale an den Signalsteckverbindern (3), welche von den Anschlussmitteln (B1,B2,B3,B4) kommen als Logik-Eingaben über die Bussteckverbinder (2) und die Rückwandbusplatine (RP1,RP2,RP3) an die Haupteinheit (IM) weiterzugeben,
- wobei die Busleiterbahnen (BL1,...,BL4) und der Lagenaufbau der Rückwandbusplatine (RP1,RP2,RP3) derart ausgestaltet sind, dass ein Schichtstapel (PCB) umfassend die Busleiterbahnen (BL1,...,BL4) und Kernmaterial (PP) Merkmale enthält, die zur Aufrechterhaltung der Signalintegrität der Signale auf der Rückwandbusplatine (RP1,RP2,RP3) erforderlich sind und somit im Hinblick auf die Signalintegrität der Signale auf der Rückwandbusplatine (RP1,RP2,RP3), diese separat auf der Hauptplatine (HP) angeordnet ist.

2. Modular aufgebautes Automatisierungssystem (1) nach Anspruch 1, wobei die Rückwandbusplatine (RP1,RP2,RP3) zwischen der Hauptplatine (HP) und einem Modul-Sockel (MS) angeordnet ist, wobei der Modul-Sockel (MS) als Befestigungsbasis für die Module (EA) ausgestaltet ist und auf der Hauptplatine (HP) angeordnet ist und der Modul-Sockel (MS) eine erste Ausnehmung (11) für einen der Modulsteckverbinder (211,...,234) und eine zweite Ausnehmung (12) für einen der Verbinder-Elemente (312,...,334) aufweist.

3. Modular aufgebautes Automatisierungssystem (1) nach Anspruch 1 oder 2, wobei ausgehend von einer ersten Rückwandbusplatine (RP1), welche über einen ersten Modulsteckverbinder (211) mit dem Busanschluss-Steckverbinder (10) der Haupteinheit (IM) verbunden ist, eine zweite Rückwandbusplatine (RP2) an die erste Rückwandbusplatine (RP1) über einen Platinenverbinder (4) angeschlossen ist.

4. Modular aufgebautes Automatisierungssystem (1) nach einem der Ansprüche 1 bis 3, wobei die Hauptplatine (HP) einen Schutzbaustein (SB) aufweist, welcher über einen Bausteinsockel (BS) in die Verbindungswege (VW1,...,VW4) geschaltet ist, und ausgestaltet ist ein Modul (EA) hinsichtlich Überspannung, Verpolung oder hochfrequenten Störungen zu schützen.

5. Modular aufgebautes Automatisierungssystem (1) nach einem der Ansprüche 1 bis 4, wobei die Hauptplatine (HP) als eine anwendungsspezifische Leiterkarte mit einem Leiterbahnlayout für Verteilwege für die Signale und die Spannungsversorgung auf einzelne anwendungsspezifische als Steckverbinder ausgestaltete Anschlussmittel (B1,B2,B3,B4), ausgestaltet ist um die Haupteinheit (IM) mit zu der spezifischen Anwendung zugehörigen Maschinenmodulen zu verbinden.

## Claims

1. Modularly assembled automation system (1) comprising
- a main unit (IM) with a plug-in bus port connector (10),
- a plurality of modules (EA) each with a plug-in bus connector (2) and a plug-in signal connector (3),
- a backplane bus board (RP1,RP2,RP3) in a layered structure with bus conductor tracks (BL1,...,BL4) is connected to a plurality of plug-in module connectors (211,...,234) in which the plug-in bus connectors (2) of the modules (EA) are arranged,
- a motherboard (HP) on which a plurality of connector elements (312,...,334) are arranged, wherein the plug-in signal connectors (3) of the modules (EA) are arranged in the connector elements (312,...,334) and the connector elements (312,...,334) are in electrical contact with conductor tracks (L1,..,L8) of the motherboard (HP),
- a plurality of connection means (B1,B2,B3,B4) which are arranged on the motherboard (HP) and are in electrical contact with the conductor tracks (L1,...,L8) of the motherboard (HP) such that electrical connection paths (VW1,...,VW4) are provided between the connector elements (312,...,334) and hence to the plug-in signal connectors (3) of the modules (EA) and the connection means (B1,B2,B3,B4), wherein the connection means (B1,B2,B3,B4) are embodied for connection to process signal cables,
- herein, the modules (EA) are embodied to communicate with the main unit (IM) via the plug-in bus connectors (2) by means of the backplane bus board (RP1,RP2,RP3) and to forward logic outputs of the main unit (IM) as signals to the plug-in signal connectors (3),
- the modules (EA) are also embodied to forward signals at the plug-in signal connectors (3) which come from the connection means (B1,B2,B3,B4) as logic inputs to the main unit (IM) via the plug-in bus connectors (2) and the backplane bus board (RP1,RP2,RP3),
- wherein the bus conductor tracks (BL1,...,BL4) and the layered structure of the backplane bus board (RP1,RP2,RP3) are embodied such that a layer stack (PCB) comprising the bus conductor tracks (BL1,...,BL4) and core material (PP) contains features necessary for maintaining the signal integrity of the signals on the backplane bus board (RP1,RP2,RP3) and thus, in respect of the signal integrity of the signals on the backplane bus board (RP1,RP2,RP3), this is arranged separately on the motherboard (HP).

2. Modularly assembled automation system (1) according to claim 1, wherein the backplane bus board (RP1,RP2,RP3) is arranged between the motherboard (HP) and a module base (MS), wherein the module base (MS) is embodied as a mounting base for the modules (EA) and arranged on the motherboard (HP) and the module base (MS) has a first recess (11) for one of the module connectors (211,...,234) and a second recess (12) for one of the connector elements (312,...,334).

3. Modularly assembled automation system (1) according to claim 1 or 2, wherein, starting from a first backplane bus board (RP1), which is connected via a first plug-in module connector (211) to the plug-in bus port connector (10) of the main unit (IM), a second backplane bus board (RP2) is connected to the first backplane bus board (RP1) via a board connector (4).

4. Modularly assembled automation system (1) according to one of claims 1 to 3, wherein the motherboard (HP) has a protection block (SB), which is connected in the connecting paths (VW1,...,VW4) via a block base (BS) and is embodied to protect a module (EA) with regard to overvoltage, polarity reversal or radio-frequency interference.

5. Modularly assembled automation system (1) according to one of claims 1 to 4, wherein the motherboard (HP) is embodied as an application-specific printed circuit card with a conductor track layout for distribution paths for the signals and the voltage supply to individual application-specific connection means (B1,B2,B3,B4) embodied as plug-in connectors in order to connect the main unit (IM) to the machine modules associated with the specific application.

## Revendications

1. Système (1) d'automatisation de constitution modulaire comprenant
- une unité (IM) principale ayant un connecteur (10) multiple à connexion de bus,
- une pluralité de modules (EA) ayant chacun un connecteur (2) multiple de bus et un connecteur (3) multiple de signal,
- une platine (RP1, RP2, RP3) de bus de paroi arrière dans une structure en couches et connectée à des pistes (BL1,...,BL4) conductrices de bus sur une pluralité de connecteurs (211,...,234) multiples de module, dans lesquels les connecteurs (2) multiples de bus des modules (EA) sont disposés,
- une platine (HP) principale sur laquelle est disposée une pluralité d'éléments (312,...,334) de connecteur, dans lequel les connecteurs (3) multiples de signal des modules (EA) sont disposés dans les éléments (312,...,334) de connecteur et les éléments (312,...,334) de connecteur sont en contact électriquement avec des pistes (L1,...,L8) conductrices de la platine (HP) principale,
- une pluralité de moyens (B1, B2, B3, B4) de connexion, qui sont disposés sur la platine (HP) principale et qui sont en contact électriquement avec les pistes (L1,...,L8) conductrices de la platine (HP) principale, de manière à avoir des chemins (VW1,...,VW4) de connexion électrique entre les éléments (312,...,334) de connecteur et ainsi aux connecteurs (3) multiples de signal des modules (EA) et les moyens (B1, B2, B3, B4) de connexion, dans lequel les moyens (B1, B2, B3, B4) de connexion sont conformés pour la connexion à un câble de signal de processus,
- les modules (EA) sont conformés pour communiquer par les connecteurs (2) multiples de bus, au moyen de la platine (RP1, RP2, RP3) de bus de paroi arrière, avec l'unité (IM) principale et pour acheminer des sorties logiques de l'unité (IM) principale comme signaux aux connecteurs (3) multiples de signal,
- les modules (EA) sont conformés également pour acheminer à l'unité (IM) principale des signaux aux connecteurs (3) multiples de signal, qui viennent des moyens (B1, B2, B3, B4) de connexion, comme entrées logiques par les connecteurs (2) multiples de bus et la platine (RP1, RP2, RP3) de bus de paroi arrière,
- dans lequel les pistes (BL1,...,BL4) conductrices de bus et la structure en couches de la platine (RP1, RP2, RP3) de bus de paroi arrière sont conformées, de manière à ce qu'une pile (PCB) de couches comprenant les pistes (BL1,...,BL4) conductrices de bus et du matériau (PP) de cœur, qui sont nécessaires au maintien de l'intégrité des signaux sur la platine (RP1, RP2, RP3) de bus de paroi arrière, et ainsi au vu de l'intégrité des signaux sur la platine (RP1, RP2, RP3) de bus de paroi arrière, celle-ci est disposée séparément sur la platine (HP) principale.

2. Système (1) d'automatisation de constitution modulaire suivant la revendication 1, dans lequel la platine (RP1, RP2, RP3) de bus de paroi arrière est disposée entre la platine (HP) principale et un socle (MS) de module, dans lequel le socle (MS) de module est conformé en base de fixation des modules (EA) et est disposé sur la platine (HP) principale et le socle (MS) de module a un premier évidement (11) pour un connecteur (211,...,234) multiple de module et un deuxième évidement (12) pour l'un des éléments (312,...,334) de connecteur.

3. Système (1) d'automatisation de constitution modulaire suivant la revendication 1 ou 2, dans lequel à partir d'une première platine (RP1) de bus de paroi arrière, qui est reliée aux connecteurs (10) multiples à connexion de bus de l'unité (IM) principale par un premier connecteur (211) multiple de modules, une deuxième platine (RP2) de bus de paroi arrière est connectée à la première platine (RP1) de bus de paroi arrière par un connecteur (4) de platine.

4. Système (1) d'automatisation de constitution modulaire suivant l'une des revendications 1 à 3, dans lequel la platine (HP) principale a un module (SB) de connexion, qui est monté par un socle (BS) de module dans les chemins (VW1, ..., VW4) de connexion et qui est conformé pour protéger un module (EA) en ce qui concerne une surtension, une polarisation ou des interférences de haute fréquence.

5. Système (1) d'automatisation de constitution modulaire suivant l'une des revendications 1 à 4, dans lequel la platine (HP) principale est conformée sous la forme d'une carte imprimée d'application spécifique ayant un layout de piste conductrice pour des chemins de répartition des signaux et l'alimentation en tension sur des moyens (B1, B2, B3, B4) de connexion spécifiques à l'application conformée en connecteur multiple, afin de relier l'unité (IM) principale aux modules de machine appartenant à l'application spécifique.
